# EUROPEAN PATENT SPECIFICATION

(11) **EP 4 350 317 B1**
(45) Date of publication and mention of the grant of the patent: **16.09.2026**
(21) Application number: 22811330.4
(22) Date of filing: 24.05.2022
(51) Int. Cl.: G01M 13/04, F16C 19/00, F16C 19/52, F16C 41/00

(54) **BEARING DEVICE STATE DETECTING METHOD, DETECTING DEVICE, AND PROGRAM**
VERFAHREN ZUR ERKENNUNG DES ZUSTANDS EINER LAGERVORRICHTUNG, ERKENNUNGSVORRICHTUNG UND PROGRAMM
PROCÉDÉ DE DÉTECTION D'ÉTAT DE DISPOSITIF À ROULEMENT, DISPOSITIF DE DÉTECTION ET PROGRAMME

(30) Priority: 28.05.2021 JP 2021090421
(43) Date of publication of application: 10.04.2024
(73) Proprietor: NSK Ltd., Tokyo 141-8560 (JP)
(72) Inventor: MARUYAMA Taisuke, Fujisawa-shi, Kanagawa 251-8501 (JP); RADZI Faidhi, Fujisawa-shi, Kanagawa 251-8501 (JP)
(74) Representative: Grünecker Patent- und Rechtsanwälte PartG mbB
(86) International application number: PCT/JP2022/021283
(87) International publication number: WO 2022/250060

(56) References cited:
- WO-A1-2005/033535
- WO-A1-2005/033535
- JP-A- 2003 214 810
- JP-A- 2020 159 754
- JP-A- 2020 159 754
- HONG SUNG-HO ET AL: "EHL Analysis of Rolling Bearings Considering the Effect of the Number of Rolling Elements and the Shaft Load", KSTLE INTERNATIONAL JOURNAL, vol. 10, no. 1, 31 December 2009 (2009-12-31), pages 17 - 22, XP093007583, ISSN: 1229-9189
- HONG SUNG-HO, KIM KYUNG-WOONG: "EHL Analysis of Rolling Bearings Considering the Effect of the Number of Rolling Elements and the Shaft Load", KSTLE INTERNATIONAL JOURNAL, vol. 10, no. 1, 31 December 2009 (2009-12-31), pages 17 - 22, XP093007583, ISSN: 1229-9189

## Description

### TECHNICAL FIELD

The present invention relates to a bearing device state detection method, a detection device, and a program. A detection method for detecting a state of a bearing device according to the preamble of claim 1, a detection device for detecting a state of a bearing device according to the preamble of claim 4, and a program according to the preamble of claim 5 are known, for example from JP 2020 159754 A.

### BACKGROUND ART

In the related arts, in a bearing device, a configuration in which a lubricant (for example, lubricating oil or grease) is used to lubricate the rotation of the bearing device has been widely used. On the other hand, by regularly performing a state diagnosis on a rotating part such as a bearing device, damage or wear may be early detected to prevent occurrence of a malfunction of the rotating part.

In a bearing device using a lubricant, to diagnose the operating state of the bearing device, it is required to appropriately detect the state of the lubricant. For example, Patent Literature 1 discloses a method of applying a low DC voltage to a bearing and diagnosing an oil film state in the bearing from a measured voltage. Patent Literature 2 discloses a method of modeling an oil film as a condenser, applying an AC voltage to the rotating wheel of a bearing in a non-contact state and estimating the oil film state of a bearing device based on a measured capacitance.

### CITATION LIST

### PATENT LITERATURE

Patent Literature 1: JPH05-003685Y
Patent Literature 2: JP4942496B

### SUMMARY OF INVENTION

### TECHNICAL PROBLEM

In recent years, there has been a demand for further lower torque in a rolling bearing. In response to the reduction in torque, progress is being made in reducing the viscosity and oil amount of a lubricant used in a rolling bearing. Here, there is a possibility that an oil film inside the rolling bearing ruptures and the contact ratio between parts increases. Therefore, in addition to oil film thickness, it is required to appropriately detect the contact state between parts inside the rolling bearing. There are various types of rolling bearings, for example, a cylindrical roller bearing and a needle roller bearing, each of which includes a rolling element in the shape of a roller. Inside such a rolling bearing, a line contact may occur between the rolling element and parts around the rolling element while the rolling bearing operates.

In view of the above problems, an objective of the present invention is to detect, with high accuracy, an oil film thickness inside a bearing device and a metal contact ratio between parts, by assuming a line contact occurring inside the bearing device.

### SOLUTION TO PROBLEM

To solve the above problems, the present invention is as defined in the appended claims.

### ADVANTAGEOUS EFFECTS OF INVENTION

According to the present invention, it is possible to detect, with high accuracy, an oil film thickness inside a bearing device and a contact ratio between parts, by assuming a line contact occurring inside a rolling bearing.

### BRIEF DESCRIPTION OF DRAWINGS

FIG. 1 is a schematic diagram showing an example of a device configuration at the time of diagnosis according to a first embodiment of the present invention.
FIG. 2 is a graph diagram showing a physical model of a bearing device according to the first embodiment of the present invention.
FIG. 3 is a circuit diagram for explaining an equivalent circuit of the bearing device according to the first embodiment of the present invention.
FIG. 4 is a circuit diagram for explaining the equivalent circuit of the bearing device according to the first embodiment of the present invention.
FIG. 5 is a diagram for explaining a rolling element (a ball) of the bearing device.
FIG. 6 is a diagram for explaining a rolling element (a roller) of the bearing device.
FIG. 7 is a diagram for explaining a verification result according to the first embodiment of the present invention.
FIG. 8A is a diagram for explaining a verification result according to the first embodiment of the present invention.
FIG. 8B is a diagram for explaining a verification result according to the first embodiment of the present invention.
FIG. 8C is a diagram for explaining a verification result according to the first embodiment of the present invention.
FIG. 8D is a diagram for explaining a verification result according to the first embodiment of the present invention.
FIG. 9A is a diagram for explaining a state of the bearing device before and after verification according to the first embodiment of the present invention.
FIG. 9B is a diagram for explaining the state of the bearing device before and after verification according to the first embodiment of the present invention.
FIG. 10 is a graph diagram for explaining a verification result according to the first embodiment of the present invention.
FIG. 11 is a flowchart of processing at the time of measurement according to the first embodiment of the present invention.

### DESCRIPTION OF EMBODIMENTS

Hereinafter, an embodiment for carrying out the present invention will be described with reference to the drawings and the like. The embodiment described below is an embodiment for explaining the present invention, and is not intended to be interpreted as limiting the present invention. Not all configurations explained in each embodiment are essential for solving problems in the present invention. In each drawing, the same reference numbers will be used to refer to the same components to indicate a corresponding relationship.

### <First Embodiment>

A first embodiment of the present invention will be described below. In the following description of a device configuration, a thrust-type needle roller bearing will be described as an example, but the present invention is not limited thereto and may be applied to bearings with other configurations. For example, radial and thrust type conical and cylindrical roller bearings in which a line contact may occur due to (needle, conical, cylindrical) rolling elements or the like, or a sliding part such as a cross roller guide where a line contact may occur may be mentioned.

### [Device Configuration]

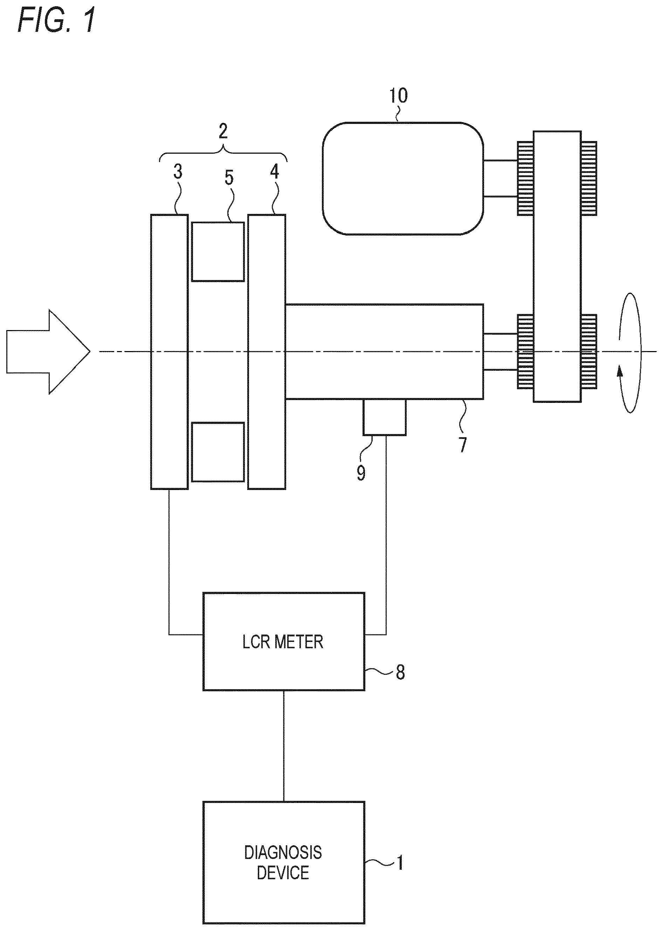

FIG. 1 is a schematic configuration diagram showing an example of an overall configuration when performing a diagnosis in a diagnosis device 1 according to the present embodiment. In FIG. 1, a bearing device 2 to which a diagnosis method according to the present embodiment is applied and the diagnosis device 1 which performs the diagnosis are provided. Note that the configuration shown in FIG. 1 is an example, and different configurations may be used depending on the configuration of the bearing device 2 and the like. In FIG. 1, the bearing device 2 is shown as including one rolling bearing, but the present invention is not limited thereto and one bearing device 2 may include a plurality of rolling bearings.

The bearing device 2 is configured to include a thrust type needle roller bearing (hereinafter also simply referred to as a rolling bearing) as a rolling bearing. In the bearing device 2, the rolling bearing rotatably supports a rotation shaft 7. As shown by an arrow in FIG. 1, the rolling bearing is applied with an axial load by a load device (not shown) in a direction perpendicular to a rotation axis. The rolling bearing includes a bearing washer 3 on a side to which an axial load is applied, a bearing washer 4 on a side which is connected to the rotation shaft 7, a plurality of rollers that are a plurality of rolling elements 5 disposed between the bearing washer 3 and the bearing washer 4, and a cage (not shown) which rotatably retains the rolling elements 5. While the configuration is such that an axial load is applied to the bearing washer 3, the bearing washer 3 and the bearing washer 4 may be reversed. Although not shown in FIG. 1, the shape of the cage is not particularly limited, and may be changed depending on the shape of the rolling elements 5 and the like. Inside the rolling bearing, friction between the bearing washer 4 and the rolling elements 5 and friction between the bearing washer 3 and the rolling elements 5 are reduced by a predetermined lubrication method. Although the lubrication method is not particularly limited, for example, grease lubrication, oil lubrication or the like is used, and is supplied to the inside of the rolling bearing. The type of a lubricant is also not particularly limited.

A motor 10 is a driving motor, and supplies rotational power to the rotation shaft 7. The rotation shaft 7 is connected to an LCR meter 8 via a rotary connector 9. The rotary connector 9 may be configured using, for example, a carbon brush, but is not limited thereto. Among the rolling bearings of the bearing device 2, the bearing washer 3 is also electrically connected to the LCR meter 8, and here, the LCR meter 8 also functions as an AC power source for the bearing device 2.

The diagnosis device 1 operates as a detection device which can execute a detection method according to the present embodiment. In diagnosis, the diagnosis device 1 instructs, as an input to the LCR meter 8, an angular frequency ω of AC power and an AC voltage V, and as an output in response to that the input, acquires an impedance |Z| (|Z| indicates an absolute value of Z) of the bearing device 2 and a phase angle θ from the LCR meter 8. Then, the diagnosis device 1 uses the values to detect an oil film thickness and a metal contact ratio in the bearing device 2. Details of the detection method will be described later.

The diagnosis device 1 may be implemented, for example, as an information processing device configured to include a control device, a storage device and an output device which are not shown. The control device may be configured by a central processing unit (CPU), a micro processing unit (MPU), a digital signal processor (DSP), a dedicated circuit, or the like. The storage device may be configured by volatile and nonvolatile storage media such as a hard disk drive (HDD), a read only memory (ROM) and a random access memory (RAM), and may input and output various types of information in response to instructions from the control device. The output device may be configured by a speaker, a light or a display device such as a liquid crystal display, and may provide a notification to a worker in response to an instruction from the control device. A notification method by the output device is not particularly limited, but may be, for example, an auditory notification using audio or a visual notification using screen output. The output device may be a network interface with a communication function, and may perform a notification operation by transmitting data to an external device (not shown) via a network (not shown). The notification content herein is not limited to a notification when an abnormality is detected, for example, when an abnormality diagnosis is performed based on a detection result, but may also include a notification notifying that the bearing device 2 is normal.

### [Physical Model]

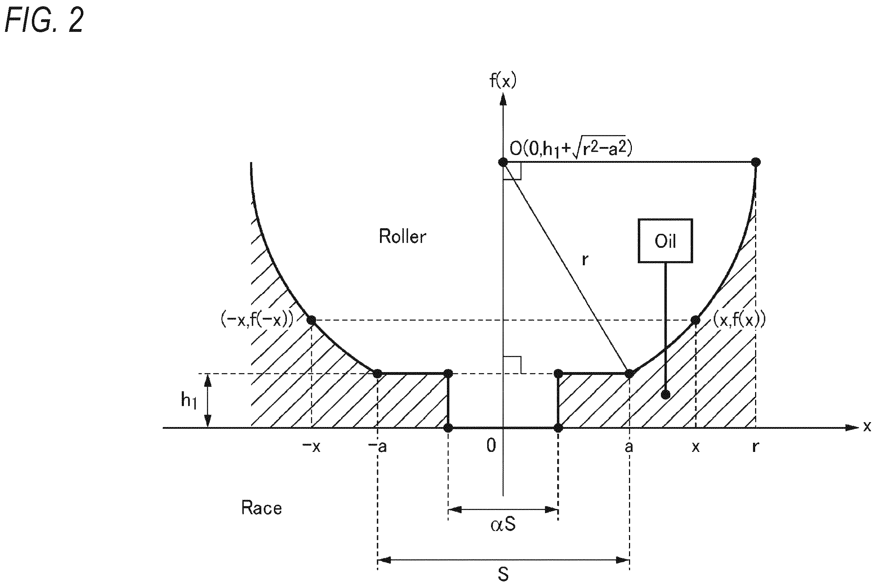

A contact state between the rolling element 5 and the bearing washer 3 (or the bearing washer 4) in the bearing device 2 will be described using FIG. 2. FIG. 2 is a graph showing a physical model when a roller piece and a race piece come into contact (herein, line contact). The roller piece corresponds to the rolling element 5 (the roller), and the race piece corresponds to the bearing washer 3 (or the bearing washer 4). An h-axis indicates an oil film thickness direction, and a y-axis indicates a direction perpendicular to the oil film thickness direction. Respective variables shown in FIG. 2 are as follows. The same variables in the respective equations used in the following explanation are given the same symbols to be associated with each other.

### S: Hertzian contact area

a: contact width of roller piece (roller) in transverse direction (here, x-axis direction)
α: oil film rupture rate (metal contact ratio) (0 ≤ α < 1)
r: radius of roller piece
αS: actual contact area (oil film rupture area)
h: oil film thickness
h₁: oil film thickness in Hertzian contact area
O: rotation center of roller piece

In a Hertzian contact area, the ratio of an area where metals are in contact to an area where the metals are not in contact is α : (1 - α). In an ideal state where the roller piece and the race piece are not in contact, α = 0, and when x = 0, h > 0.

The oil film thickness h shown in FIG. 2 is expressed by the following equation (1). The value of S shown here corresponds to a range in the x-axis direction of FIG. 1. $h = f \left(x\right) = {h}_{1} + √ \left({r}^{2}-{a}^{2}\right) - √ \left({r}^{2}-{x}^{2}\right) \left(-r\leq x<-a or a<x\leq r\right)$

In the Hertzian contact area, there may be a thin area of oil film called a horseshoe shape, but in the present embodiment, an average oil film thickness hₐ is used as an average oil film thickness in the Hertzian contact area. Therefore, when the oil film ruptures in the Hertzian contact area, hₐ may be calculated by the following equation (2). ${h}_{a} = \left(1-α\right) {h}_{1}$

In FIG. 2, O represents that x = 0, and the coordinates of O in FIG. 2 are indicated by O(0, h₁ + √(r² - a²)).

In an actual rolling bearing, the rolling element 5 undergoes elastic deformation when receiving a load. Thus, strictly speaking, the cross section thereof is not a perfect circle, but in the present embodiment, the above equation (1) is used assuming that the cross section thereof is a perfect circle. Therefore, an equation used to determine an oil film thickness is not limited to the equation (1), and other calculation equations may be used (for example, in the case of a gear, an involute curve).

### [Equivalent Electrical Circuit]

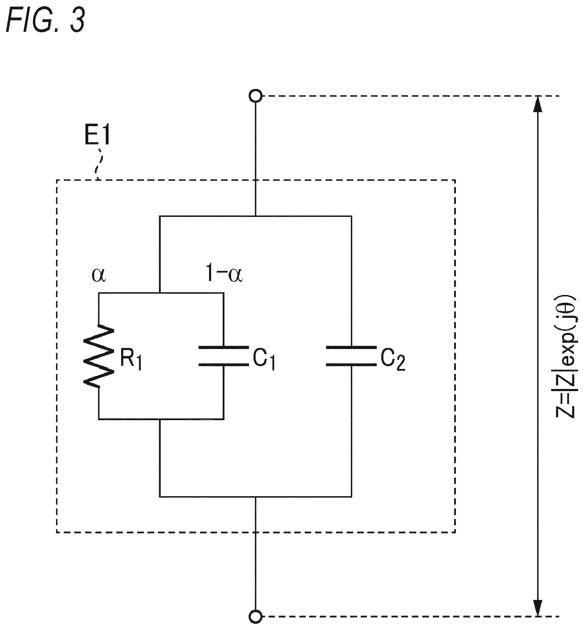

FIG. 3 is a diagram showing the physical model shown in FIG. 2 using an electrically equivalent electrical circuit (equivalent circuit). The equivalent circuit E1 is configured by a resistor R₁, a condenser C₁ and a condenser C₂. The resistor R₁ corresponds to a resistor in a rupture area (= αS). The condenser C₁ corresponds to a condenser formed by an oil film in the Hertzian contact area, and has a capacitance C₁. The condenser C₂ corresponds to a condenser formed by an oil film around the Hertzian contact area (-r ≤ x < -a and a < x ≤ r in FIG. 2), and has a capacitance C₂. The Hertzian contact area (= S) forms a parallel circuit of the resistor R₁ and the condenser C₁ in the equivalent circuit E1 of FIG. 3. The condenser C₂ is connected in parallel to the electrical circuit configured by the resistor R₁ and the condenser C₁. Here, it is assumed that the area around the Hertzian contact area (-r ≤ x < -a and a < x ≤ r in FIG. 2) is filled with a lubricant.

The impedance of the equivalent circuit E1 is indicated by Z. The AC voltage V applied to the equivalent circuit E1, the current I flowing through the equivalent circuit E1 and the complex impedance Z of the entire equivalent circuit E1 are expressed by the following equations (3) to (5). $V = \left|V\right| exp \left(jωt\right)$ $I = \left|I\right| exp \left(j\left(ωt-θ\right)\right)$ $Z = V / I = \left|V/I\right| exp \left(jθ\right) = \left|Z\right| exp \left(jθ\right)$
j: imaginary number
ω: angular frequency of AC voltage
t: time
θ: phase angle (phase shift between voltage and current)

As shown in equation (5), the complex impedance Z is expressed by two independent variables of the absolute value |Z| of Z and the phase angle θ. Accordingly, by measuring the complex impedance Z, two mutually independent parameters (in the present embodiment, hₐ and α shown below) may be measured. The complex impedance Z of the entire equivalent circuit shown in FIG. 3 is expressed as in the following equation (6). ${Z}^{- 1} = {{R}_{1}}^{- 1} + jω \left({C}_{1}+{C}_{2}\right)$
R₁: resistance value of resistor R₁
C₁: capacitance of condenser C₁
C₂: capacitance of condenser C₂
|Z|: impedance in dynamic contact state

The following equations (7) and (8) may be derived from the equation (6). ${R}_{1} = \left|Z\right| / cosθ$ $ω \left({C}_{1}+{C}_{2}\right) = - sinθ / \left|Z\right|$

Since R₁ in the equation (7) is inversely proportional to the contact area, R₁ may be expressed as in the following equation (9). ${R}_{1} = {R}_{10} / α$ R₁₀: resistance value when stopped (that is, α = 1)

R₁₀ may be expressed as in the following equation (10). ${R}_{10} = \left|{Z}_{0}\right| / cos {θ}_{0}$
|Z₀|: impedance in static contact state
θ₀: phase angle in static contact state

Accordingly, the rupture rate α may be expressed as in the following equation (11) from the equation (7), the equation (9) and the equation (10). As described above, when θ₀ is a phase angle in a static contact state, θ may be regarded as a phase angle in a dynamic contact state.

[Math Figure 1] $α = \frac{\left|{Z}_{0}\right| cos θ}{\left|Z\right| {cosθ}_{0}}$

On the other hand, C₁ in the equations (6) and (8) may be expressed as in the following equation (12). When assuming line contact, the contact area of the Hertzian contact area S becomes S = 2aL when the length of the rolling element (roller) (here, a contact width in a longitudinal direction) is L.

[Math Figure 2] ${C}_{1} = \frac{ε \left(1-α\right) S}{{h}_{1}} = \frac{2 ε \left(1-α\right) aL}{{h}_{1}}$
ε: dielectric constant of lubricant
C₂ in the equations (6) and (8) may be expressed as in the following equation (13).

[Math Figure 3] ${C}_{2} = 2 ε {\int }_{a}^{r} \frac{Ldx}{f \left(x\right)} \approx 2 πεL \sqrt{\frac{r}{2 {h}_{1}}}$

### [Capacitance According to Contact State]

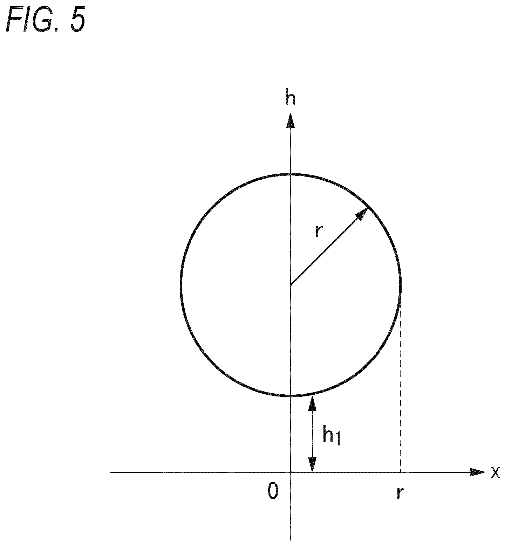

Here, C₂ in a point contact will be described. FIG. 5 is a diagram for explaining a case where the rolling element is a ball (for example, a ball bearing). Although the value of h₁ is shown herein to be large for ease of explanation, in reality, as shown in FIG. 2, the value of h₁ is small such that a contact (a point contact in this case) occurs. Here, a point contact may occur between the rolling element and the bearing washer. Similarly to FIG. 2, when the radius of the rolling element is r and the oil film thickness is h₁, the capacitance of the condenser C₂ in the equivalent circuit shown in FIG. 3 may be calculated as in the following equation (14).

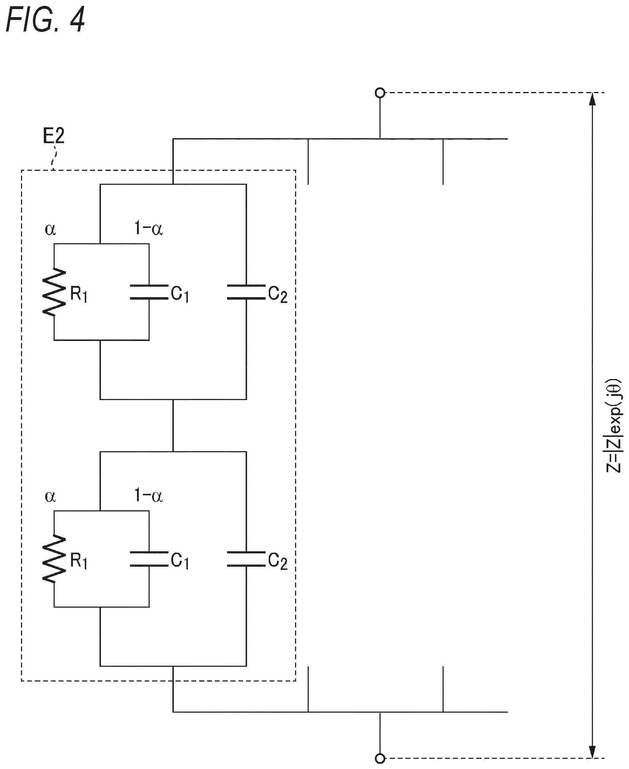

[Math Figure 4] ${C}_{2} = 2 πεr ln \left(\frac{r}{{h}_{1}}\right)$
π: pi
r: radius of ball
ε: dielectric constant of lubricant
ln: logarithmic function

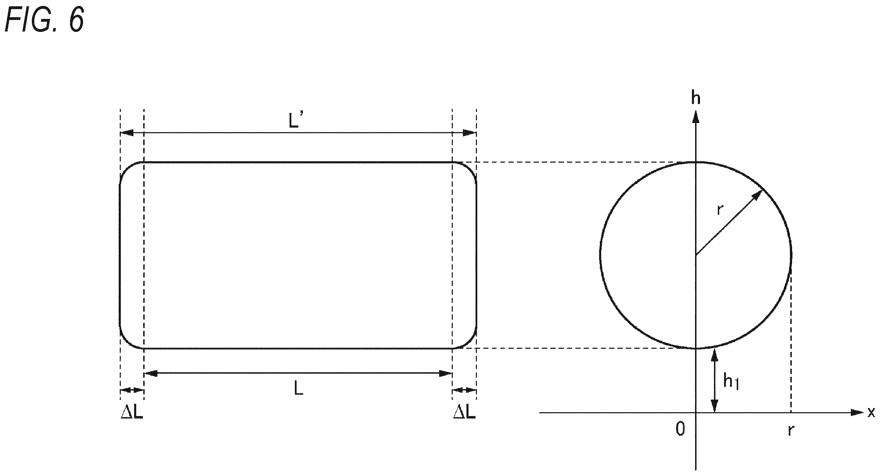

Next, a case where a line contact handled in the present embodiment occurs will be explained. FIG. 6 is a diagram for explaining a case where the rolling element is a roller (for example, a roller bearing). As in FIG. 5, although the value of h₁ is shown to be large for ease of explanation, in reality, as shown in FIG. 2, the value of h₁ is small such that a contact (a line contact in this case) occurs. Here, a line contact may occur between the rolling element and the bearing washer. Similarly to FIG. 2, when the radius of the rolling element is r and the oil film thickness is h₁, the capacitance of the condenser C₂ in the equivalent circuit shown in FIG. 3 may be calculated as in the above equation (13).

As shown in FIG. 6, there is a case where the roller used in the rolling bearing is formed with chamfered ends. Here, a straight line portion where a line contact may occur may be treated as L. When a length ΔL in the longitudinal direction due to chamfering is extremely small compared to L, the condenser C₂ may be calculated using a length L' (= L + 2ΔL) including chamfered portions.

Here, by using the symbols shown in FIGS. 2 and 6, the contact area by the line contact (that is, the contact area of the Hertzian contact area S) may be expressed as 2aL.

A point contact instead of a line contact may occur in the chamfered portion. Therefore, for the chamfered portion, the condenser C₂ may be added to the calculation equation (13) by using a calculation equation (for example, the above equation (14)) for C₂ in the case of a point contact.

An example will be shown in which a calculation result of the condenser C₂ is verified using a theoretical equation defined in the above equation (13). A comparison with a result of simulation analysis using the finite element method that is one known method of electromagnetic field analysis is shown. The following equation (15) by Jackson, that is a known calculation equation, is shown as a comparison target. Jackson's equation assumes that h₁ is extremely large compared to r.

[Math Figure 5] ${C}_{2} = \frac{2 πεL}{arcosh \left(\frac{{h}_{1}}{r}+2\right)}$

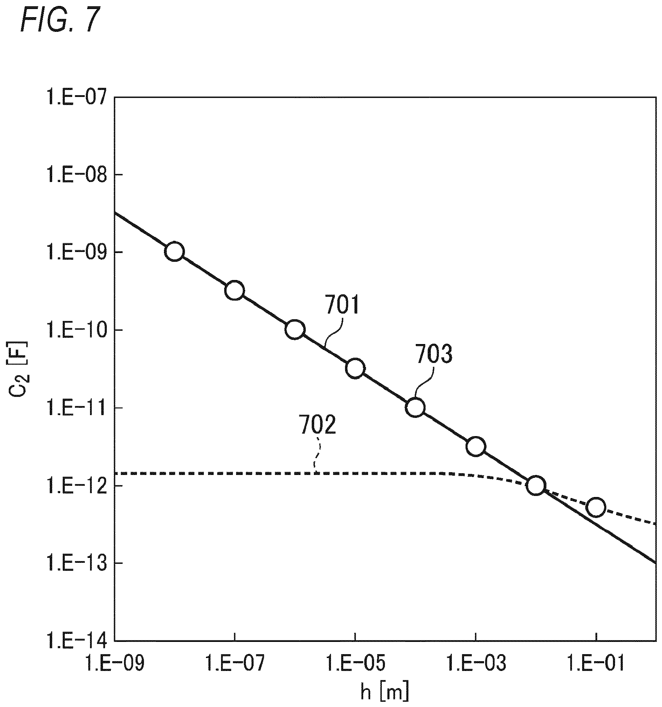

FIG. 7 is a graph showing verification results, where the horizontal axis shows the oil film thickness h₁ [m] and the vertical axis shows the capacitance C₂ [F]. A line 701 shows a result of calculating the capacitance C₂ using the equation (13) that is the calculation equation according to the present embodiment. A line 702 shows a result of calculating the capacitance C₂ using the equation (15) that is the calculation equation by Jackson. A symbol 703 (∘) indicates a result obtained by simulation using the finite element method.

As shown by the line 701 and the symbol 703 in FIG. 7, the value of the capacitance C₂ calculated using the equation (13) may lead to almost the same value as the simulation result in the range of 1.0⁻² ≥ h. The range corresponds to the size of the rolling bearing assumed in the present invention (h₁ is extremely small compared to r), and a high accuracy may be obtained even when compared to the line 702 based on Jackson's equation (15).

### [Derivation of Oil Film Thickness and Oil Film Rupture Rate]

In the present embodiment, a lubrication state is detected using the oil film thickness h₁ of the lubricant and the oil film rupture rate α of the oil film, as described above. The following equation (16) is derived from the equations (8) and (11) to (13) described above.

[Math Figure 6] ${h}_{1} = \frac{8 {\left(1-α\right)}^{2} {a}^{2}}{r} {\left(\frac{1 + \sqrt{1 + ψ}}{πψ}\right)}^{2}$

Here, ψ is defined as in the following equation (17).

[Math Figure 7] $ψ = - \frac{4 \left(1-α\right) a sin θ}{{π}^{2} rLεω \left|Z\right|}$
L: length of rolling element (roller)

From the equations (2) and (16), the average oil film thickness hₐ is derived as in the following equation (18).

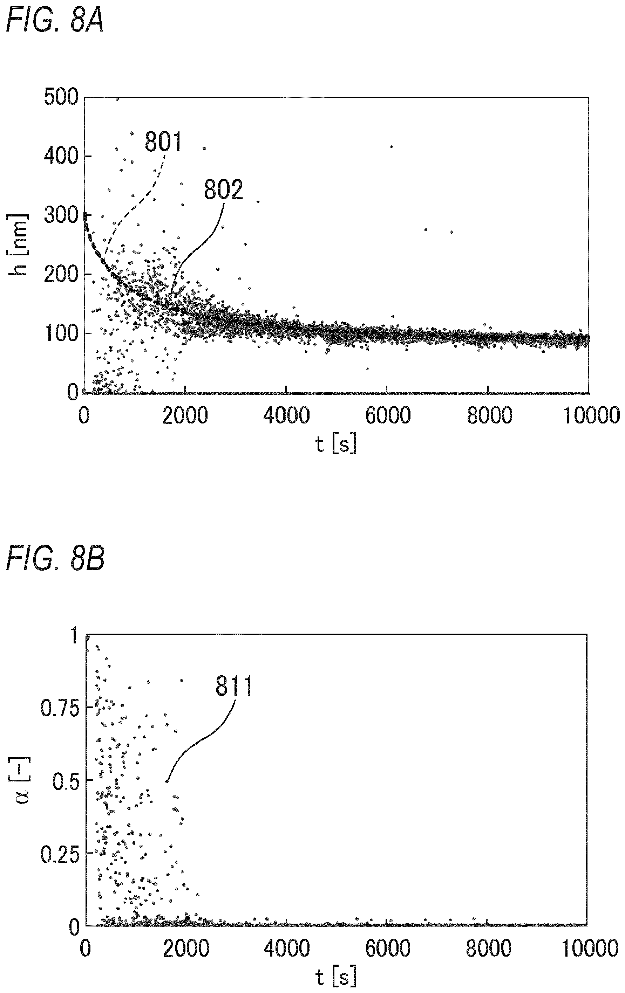

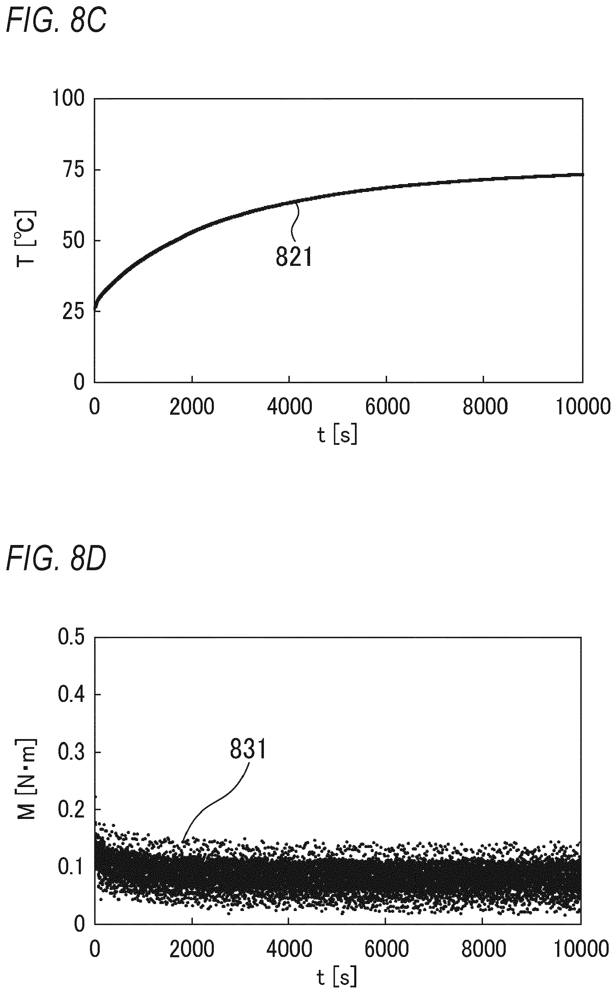

[Math Figure 8] ${h}_{a} = \frac{8 {\left(1-α\right)}^{3} {a}^{2}}{r} {\left(\frac{1 + \sqrt{1 + ψ}}{πψ}\right)}^{2}$

In other words, by the equations (11) and (18), by measuring the complex impedance and the phase angle when stopped and when the oil film is formed, it is possible to simultaneously monitor hₐ and α.

The above equation (18) is a theoretical equation when there is one contact area. In a rolling bearing, a plurality of contact areas may exist due to the configuration thereof. For example, in the case of a roller bearing as shown in FIG. 1, there may be two contact areas (on the side of the bearing washer 3 and the side of the bearing washer 4) corresponding to one rolling element. Here, the equivalent circuit may be regarded to be configured by two of the equivalent circuit shown in FIG. 3 connected in series.

FIG. 4 is a diagram showing an electrically equivalent electrical circuit around one rolling element 5 based on the equivalent circuit E1 shown in FIG. 3. Focusing on one rolling element 5, the equivalent circuit E1 is formed between the bearing washer 3 and the rolling element 5 and between the bearing washer 4 and the rolling element 5. Description will be made assuming that the upper side is an electrical circuit formed by the bearing washer 3 and the rolling element 5 and the lower side is an electrical circuit formed by the bearing washer 4 and the rolling element 5, but the directions may be reversed. Thus, around one rolling element 5, an equivalent circuit E2 is formed by two equivalent circuits E1 connected in series.

In such a configuration, when the number of contact areas connected in series is l and the number of rolling elements is n, ψ may be expressed as in the following equation (19).

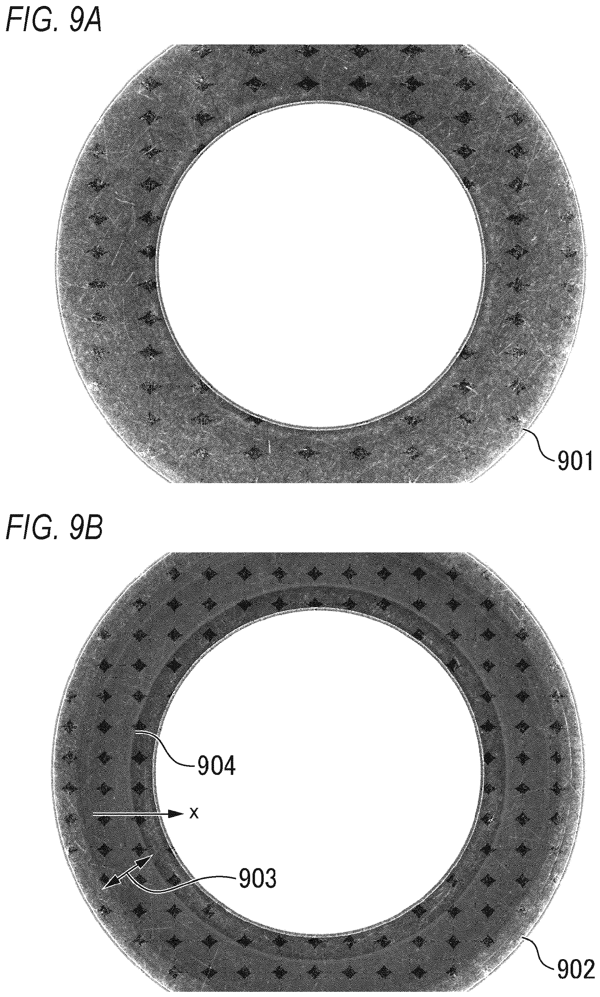

[Math Figure 9] $ψ = - \frac{4 \left(1-α\right) la sin θ}{{π}^{2} nrLεω \left|Z\right|}$
l: number of contact areas per rolling element
n: number of rolling elements
L: length of rolling element (roller)

As described above, an equivalent circuit to be considered differs depending on the number of contact areas where line contacts occur. In the example of FIG. 4, the equivalent circuit E2 is shown assuming there are two contact areas of line contacts. As shown in the equations (18) and (19), by including the number of contact areas as a variable, the method according to the present embodiment may be applied to perform detection by assuming a single contact area of a line contact, or may be applied to perform detection by assuming a plurality of contact areas of line contacts. In other words, by using the equations (18) and (19), it is possible to detect an oil film thickness and a rupture rate in one line contact by taking the number of line contacts into consideration.

### [Verification Result]

Next, results of performing verification using the calculation equations according to the present embodiment will be shown. Here, verification performed using a thrust needle roller bearing will be described. FIGS. 8A to 8D are diagrams showing verification results of various types of data by the method according to the present embodiment. In FIG. 8A, the horizontal axis indicates time t [s], and the vertical axis indicates oil film thickness h. In the present example, the film thickness h corresponds to the average oil film thickness hₐ. In FIG. 8B, the horizontal axis indicates time t [s], and the vertical axis indicates rupture rate α. In FIG. 8C, the horizontal axis indicates time t [s], and the vertical axis indicates temperature T [°C]. In FIG. 8D, the horizontal axis indicates time t [s], and the vertical axis indicates torque M [N·m]. In each drawing, time on the horizontal axis indicates elapsed time since a bearing starts to rotate, and correspond to each other.

The conditions used in the verification shown in FIGS. 8A to 8D are as follows.
Bearing: thrust needle roller bearing (product number: FNTA2542)
Axial load: 1.5 [kN]
Radial load: 0 [N]
Rotation speed: 3000 [m⁻¹]
Temperature: 25 [°C]
Lubricant: VG32 (ISO)
Oil amount: 1.0 ml
Relative permittivity: 2.3
AC voltage: 0.2 [V]
AC power frequency: 1.0 [MHz]

Referring to FIG. 8A, a line 801 indicates a theoretical value by the Dowson-Higginson equation as a comparative example. Points 802 indicate calculation results according to the present embodiment. According to FIG. 8A, with the lapse of time, the points 802 stabilize to approximate the value indicated by the line 801. Specifically, when 4000 seconds elapsed, the oil film thickness h stabilizes to a value close to 100 [nm].

Referring to FIG. 8B, as shown by points 811, the rupture rate α is not stable at the beginning of rotation. Thereafter, when 2000 seconds elapsed since the start of rotation, the rupture rate α has stabilized to a value close to 0.

Referring to FIG. 8C, as shown by a line 821, the temperature of the bearing increases with the lapse of time. When the temperature of the bearing increases, the viscosity of the lubricant decreases, and the oil film becomes thin as shown in FIG. 8A.

Referring to FIG. 8D, as shown by points 831, a torque value is higher at the beginning of rotation than after a certain period of time has lapsed. This may also be explained by a decrease in viscosity due to a rise in temperature.

FIGS. 9A and 9B are diagrams showing the states of the rolling bearing before and after verification. As mentioned above, in the present verification, an example using a thrust needle roller bearing is shown. FIG. 9A shows a rolling surface 901 (corresponding to the race piece shown in FIG. 2) of the rolling bearing before verification. FIG. 9B shows a rolling surface 902 of the bearing after verification. As shown in FIG. 9B, traces 903 are formed on the rolling surface 902 after the rolling element (the roller) has rolled. A boundary 904 indicates the inner end of the traces 903.

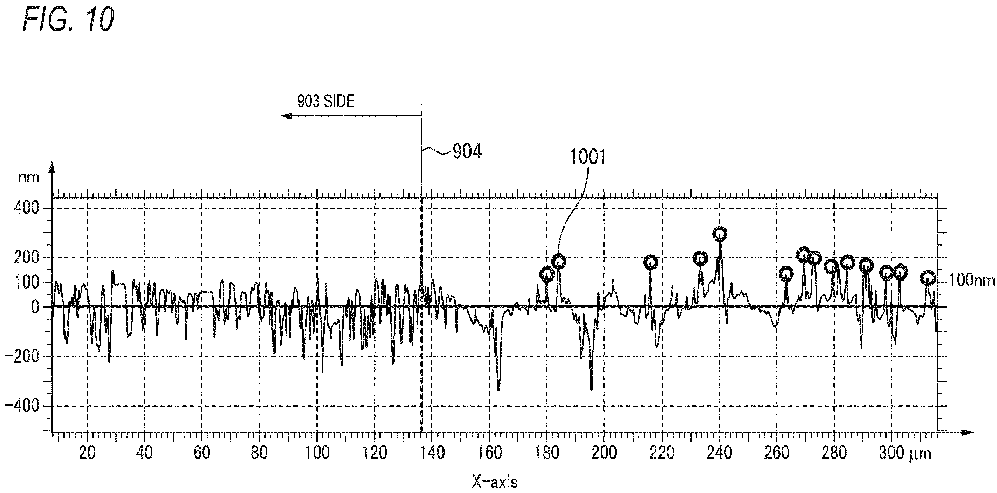

FIG. 10 is a graph showing the unevenness of the rolling surface 902 after the verification shown in FIG. 9B. Here, the unevenness of the position indicated by the arrow in FIG. 9B is shown. In FIG. 10, the vertical axis indicates the depth [nm] of the unevenness with a certain position as a reference 0, and the horizontal axis indicates the position [µm] of an axis (here, the x-axis) along the arrow shown in FIG. 9B.

In FIG. 10, the left side of a boundary 904 corresponds to a position where the trace 903 is formed by rolling of the rolling element (the roller). On the other hand, the right side of the boundary 904 corresponds to a position where the rolling element (the roller) does not roll (does not contact).

Referring to FIG. 8B, when the rolling bearing starts rotating and 2000 seconds elapsed, α ≈ 0. This can be thought as because, as shown in FIG. 10, the unevenness of the rolling surface 902 is reduced due to the rotation of the rolling element. In the example of FIG. 10, an upper limit is around 100 nm on the left side of the boundary 904. This is consistent with the fact that, as shown in FIG. 8A, the oil film thickness h after 10,000 seconds elapsed stabilizes to a value close to 100 [nm]. Namely, this means that it is possible to monitor the running-in wear process of the rolling bearing (such as a time until running-in is completed).

### [Processing Flow]

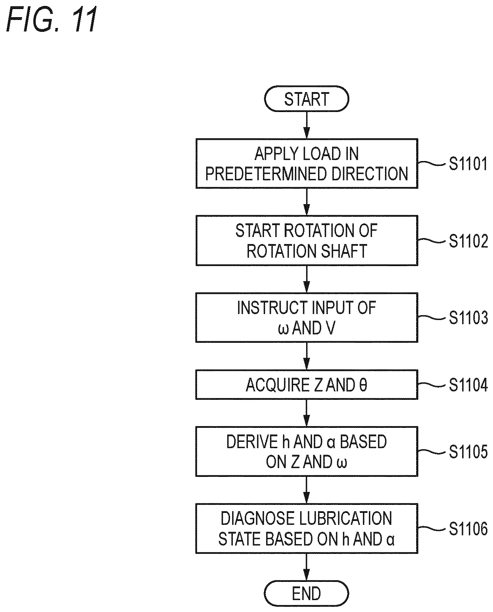

FIG. 11 is a flowchart of a diagnostic processing according to the present embodiment. The processing is executed by the diagnosis device 1, and may be implemented as, for example, the control device (not shown) included in the diagnosis device 1 reads and executes a program for implementing the processing according to the present embodiment from the storage device (not shown).

In S1101, the diagnosis device 1 performs control so that a load is applied to the bearing device 2 in a predetermined direction (here, at least in the axial direction). In the case of the configuration of FIG. 1, an axial load is applied to the bearing washer 3. The control to apply the load may be performed by a device different from the diagnosis device 1. Here, a phase angle and an impedance in a static contact state are measured.

In S1102, the diagnosis device 1 starts the rotation of the rotation shaft 7 by the motor 10. Accordingly, rotation of the bearing washer 4 connected to the rotation shaft 7 is started. The control of the motor 10 may be performed by a device other than the diagnosis device 1.

In S1103, the diagnosis device 1 controls the LCR meter 8 so that the AC voltage of an angular frequency ω is applied to the bearing device 2 using an AC power source (not shown) included in the LCR meter 8. Accordingly, the AC voltage of the angular frequency ω is applied to the bearing device 2.

In S1104, the diagnosis device 1 obtains an impedance |Z| and a phase angle θ from the LCR meter 8 as outputs in response to the inputs in S1103. That is, the LCR meter 8 outputs the impedance |Z| and the phase angle θ to the diagnosis device 1 as detection results of the bearing device 2 with respect to the AC voltage V and the angular frequency ω of the AC voltage as inputs.

In S1105, the diagnosis device 1 derives the oil film thickness h (hₐ in the present embodiment) and the rupture rate α by applying the impedance |Z| and the phase angle θ acquired in S1104 and the angular frequency ω of the AC voltage used in S1103 to the equations (11), (18) and (19).

In S1106, the diagnosis device 1 diagnoses the lubrication state of the bearing device 2 using the oil film thickness h and the rupture rate α derived in S1105. The diagnosis method herein may determine the lubrication state, for example, by setting threshold values for the oil film thickness h and the rupture rate α and comparing the oil film thickness h and the rupture rate α with the threshold values. Then, the processing flow ends.

From the above description, according to the present embodiment, it is possible to detect, with high accuracy, an oil film thickness inside a bearing device and a contact ratio between parts, by assuming a line contact occurring inside a rolling bearing.

### <Other Embodiments>

Although the above embodiment has been described using a roller bearing as an example, the calculation method according to the present invention may also be applied to measurement of other objects. For example, the calculation method may be applied to a sliding bearing, a gear, or the like. Even then, it is possible to perform verification with the same accuracy as the verification results shown in FIG. 6.

In the present invention, a program or an application for implementing the functions of at least one embodiment described above may be supplied to a system or a device using a network or a storage medium, and may be implemented by a process in which at least one processor in a computer of the system or the device reads and executes a program.

The program or the application may be implemented by a circuit which implements at least one function (for example, an application specific integrated circuit (ASIC) or a field programmable gate array (FPGA)).

The present application is based on Japanese patent application (Japanese Patent Application No. 2021-090421) filed on May 28, 2021.

### REFERENCE SIGNS LIST

1 ... Diagnosis device
2 ... Bearing device
3, 4 ... Bearing washer
5 ... Rolling element
7 ... Rotation axis
8 ... LCR meter
9 ... Rotating connector
10 ... Motor

## Claims

1. A detection method for detecting a state of a bearing device (2) including a plurality of rollers (5) and first and second members configuring rolling surfaces of the plurality of rollers (5), the method comprising:
applying an AC voltage to an electrical circuit configured by the plurality of rollers (5) and the first and second members;
measuring an impedance and a phase angle of the electrical circuit when applying the AC voltage; and
deriving, based on the impedance and the phase angle, an oil film thickness and a metal contact ratio in at least one of between the first member and the plurality of rollers (5) and between the second member and the plurality of rollers (5), wherein
the oil film thickness (hₐ) and the metal contact ratio (α) are derived using a calculation equation corresponding to an electrical circuit configured by a line contact occurring between a roller (5) and at least one of the first and second members in the bearing device (2), and wherein
the electrical circuit configured by the line contact is configured by a resistor formed by the line contact, a first condenser configured by a lubricant positioned within a predetermined range from the line contact, and a second condenser configured by a lubricant positioned outside the predetermined range, **characterized in that**
the oil film thickness is an oil film thickness within the predetermined range, and
the calculation equation for deriving the oil film thickness hₐ and the metal contact ratio α is as follows: $α = \frac{\left|{Z}_{0}\right| cos θ}{\left|Z\right| {cosθ}_{0}}$ ${h}_{a} = \frac{8 {\left(1-α\right)}^{3} {a}^{2}}{r} {\left(\frac{1 + \sqrt{1 + ψ}}{πψ}\right)}^{2}$ and $ψ = - \frac{4 \left(1-α\right) la sin θ}{{π}^{2} nrLεω \left|Z\right|}$
α: metal contact ratio (0 ≤ α < 1)
Z: complex impedance
Z₀: complex impedance (when stopped)
θ: phase angle
θ₀: phase angle (when stopped)
r: radius of roller
a: contact width in transverse direction of roller
l: number of contact areas per roller
n: number of rollers
L: length of roller
ω: angular frequency of AC voltage
ε: dielectric constant of lubricant
π: pi.

2. The detection method according to claim 1, wherein a capacitance C₁ of the first condenser is expressed by ${C}_{1} = \frac{2 ε \left(1-α\right) aL}{{h}_{1}}$ and a capacitance C₂ of the second condenser is expressed by ${C}_{2} = 2 πεL \sqrt{\frac{r}{2 {h}_{1}}}$ h₁: oil film thickness in Hertzian contact area.

3. The detection method according to claim 1 or 2, wherein the bearing device (2) is diagnosed using the oil film thickness and the metal contact ratio.

4. A detection device for detecting a state of a bearing device (2) configured by a plurality of rollers (5) and first and second members configuring rolling surfaces of the plurality of rollers (5), the device comprising:
an acquisition unit configured to acquire an impedance and a phase angle of an electrical circuit, configured by the plurality of rollers (5) and the first and second members, upon application of an AC voltage, obtained when the AC voltage is applied to the electrical circuit; and
a derivation unit configured to derive an oil film thickness (hₐ) and a metal contact ratio (α) in at least one between the first member and the plurality of rollers (5) and between the second member and the plurality of rollers (5) based on the impedance and the phase angle, wherein
the derivation unit derives the oil film thickness and the metal contact ratio by using a calculation equation corresponding to an electrical circuit configured by a line contact occurring between a roller (5) and at least one of the first and second members in the bearing device (2), wherein the electrical circuit configured by the line contact is configured by a resistor formed by the line contact, a first condenser configured by a lubricant positioned within a predetermined range from the line contact, and a second condenser configured by a lubricant positioned outside the predetermined range, **characterized in that**
the oil film thickness (hₐ) is an oil film thickness within the predetermined range, and
the calculation equation for deriving the oil film thickness hₐ and the metal contact ratio α is as follows: $α = \frac{\left|{Z}_{0}\right| cos θ}{\left|Z\right| {cosθ}_{0}}$ ${h}_{a} = \frac{8 {\left(1-α\right)}^{3} {a}^{2}}{r} {\left(\frac{1 + \sqrt{1 + ψ}}{πψ}\right)}^{2}$ and $ψ = - \frac{4 \left(1-α\right) la sin θ}{{π}^{2} nrLεω \left|Z\right|}$
α: metal contact ratio (0 ≤ α < 1)
Z: complex impedance
Z₀: complex impedance (when stopped)
θ: phase angle
θ₀: phase angle (when stopped)
r: radius of roller
a: contact width in transverse direction of roller
l: number of contact areas per roller
n: number of rollers
L: length of roller
ω: angular frequency of AC voltage
ε: dielectric constant of lubricant
π: pi.

5. A program causing a computer to function as:
an acquisition unit configured to acquire, for a bearing device (2), an impedance and a phase angle of an electrical circuit, configured by a plurality of rollers (5) configuring the bearing device (2) and first and second members configuring rolling surfaces of the plurality of rollers (5), upon application of an AC voltage, obtained when the AC voltage is applied to the electrical circuit; and
a derivation unit configured to derive an oil film thickness (hₐ) and a metal contact ratio (α) in at least one between the first member and the plurality of rollers (5) and between the second member and the plurality of rollers (5) based on the impedance and the phase angle, wherein
the derivation unit derives the oil film thickness and the metal contact ratio by using a calculation equation corresponding to an electrical circuit configured by a line contact occurring between a roller (5) and at least one of the first and second members in the bearing device (2), wherein the electrical circuit configured by the line contact is configured by a resistor formed by the line contact, a first condenser configured by a lubricant positioned within a predetermined range from the line contact, and a second condenser configured by a lubricant positioned outside the predetermined range, **characterized in that**
the oil film thickness (hₐ) is an oil film thickness within the predetermined range, and
the calculation equation for deriving the oil film thickness hₐ and the metal contact ratio α is as follows: $α = \frac{\left|{Z}_{0}\right| cos θ}{\left|Z\right| {cosθ}_{0}}$ ${h}_{a} = \frac{8 {\left(1-α\right)}^{3} {a}^{2}}{r} {\left(\frac{1 + \sqrt{1 + ψ}}{πψ}\right)}^{2}$ and $ψ = - \frac{4 \left(1-α\right) la sin θ}{{π}^{2} nrLεω \left|Z\right|}$
α: metal contact ratio (0 ≤ α < 1)
Z: complex impedance
Z₀: complex impedance (when stopped)
θ: phase angle
θ₀: phase angle (when stopped)
r: radius of roller
a: contact width in transverse direction of roller
l: number of contact areas per roller
n: number of rollers
L: length of roller
ω: angular frequency of AC voltage
ε: dielectric constant of lubricant
π: pi.

## Patentansprüche

1. Erfassungsverfahren zum Erfassen eines Zustandes einer Lagerungsvorrichtung (2), die eine Vielzahl von Rollen (5) sowie ein erstes und ein zweites Element einschließt, die Rollflächen der Vielzahl von Rollen (5) bilden, wobei das Verfahren umfasst:
Anlegen einer Wechselspannung an einen Stromkreis, der durch die Vielzahl von Rollen (5) sowie das erste und das zweite Element gebildet wird;
Messen einer Impedanz und eines Phasenwinkels des Stromkreises beim Anlegen der Wechselspannung; sowie
Herleiten einer Ölfilm-Dicke sowie eines Metall-Festkörper-Kontaktverhältnisses wenigstens zwischen dem ersten Element und der Vielzahl von Rollen (5) oder zwischen dem zweiten Element und der Vielzahl von Rollen (5), wobei
die Ölfilm-Dicke (hₐ) und das Metall-Festkörper-Kontaktverhältnis (α) unter Verwendung einer Berechnungsgleichung hergeleitet werden, die einem Stromkreis entspricht, der durch einen Linienkontakt gebildet wird, der zwischen einer Rolle (5) und wenigstens dem ersten oder dem zweiten Element in der Lagerungsvorrichtung (2) auftritt, und wobei
der durch den Linienkontakt gebildete Stromkreis durch einen Widerstand, der von dem Linienkontakt ausgebildet wird, einen ersten Kondensator, der durch ein Schmiermittel gebildet wird, das innerhalb eines vorgegebenen Bereiches von dem Linienkontakt aus positioniert ist, sowie einen zweiten Kondensator ausgebildet wird, der durch ein Schmiermittel gebildet wird, das außerhalb des vorgegebenen Bereiches positioniert ist, **dadurch gekennzeichnet, dass**
die Ölfilm-Dicke eine Ölfilm-Dicke innerhalb des vorgegebenen Bereiches ist, und
die Berechnungsgleichung zum Herleiten der Ölfilm-Dicke hₐ sowie des Metall-Festkörper-Kontaktverhältnisses α wie folgt lautet: $α = \frac{\left|{Z}_{0}\right| cos θ}{\left|Z\right| cos {θ}_{0}}$ ${h}_{a} = \frac{8 {\left(1-α\right)}^{3} {a}^{2}}{r} {\left(\frac{1 + \sqrt{1 + ψ}}{πψ}\right)}^{2}$ und $ψ = - \frac{4 \left(1-α\right) la sin θ}{{π}^{2} nrLεω \left|Z\right|}$
α: Metall-Festkörper-Kontaktverhältnis (0 ≤ α < 1)
Z: komplexe Impedanz
Z₀: komplexe Impedanz (wenn angehalten)
θ: Phasenwinkel
θ₀: Phasenwinkel (wenn angehalten)
r: Radius von Rolle
a: Kontaktbreite in Querrichtung von Rolle
I: Anzahl von Kontaktbereichen pro Rolle
n: Anzahl von Rollen
L: Länge von Rolle
ω: Winkelfrequenz von Wechselspannung
ε: Dielektrizitätskonstante von Schmiermittel
π: pi.

2. Erfassungsverfahren nach Anspruch 1, wobei eine Kapazität C₁ des ersten Kondensators ausgedrückt wird durch ${C}_{1} = \frac{2 ε \left(1-α\right) aL}{{h}_{1}}$ und eine Kapazität C₂ des zweiten Kondensators ausgedrückt wird durch ${C}_{2} = 2 πεL \sqrt{\frac{r}{2 {h}_{1}}}$ h₁: Ölfilm-Dicke an Hertzscher Kontaktfläche.

3. Erfassungsverfahren nach Anspruch 1 oder 2, wobei die Lagerungsvorrichtung (2) unter Verwendung der Ölfilm-Dicke und des Metall-Festkörper-Kontaktverhältnisses diagnostiziert wird.

4. Erfassungsvorrichtung zum Erfassen eines Zustandes einer Lagerungsvorrichtung (2), die durch eine Vielzahl von Rollen (5) sowie ein erstes und ein zweites Element gebildet wird, die Rollflächen der Vielzahl von Rollen (5) bilden, wobei die Vorrichtung umfasst:
eine Bestimmungs-Einheit, die so ausgeführt ist, dass sie eine Impedanz und einen Phasenwinkel eines Stromkreises, der durch die Vielzahl von Rollen (5) sowie das erste und das zweite Element gebildet wird, beim Anlegen einer Wechselspannung bestimmt, die erzeugt werden, wenn die Wechselspannung an den Stromkreis angelegt wird; und
eine Herleitungs-Einheit, die so ausgeführt ist, dass sie eine Ölfilm-Dicke (hₐ) und ein Metall-Festkörper-Kontaktverhältnis (α) wenigstens zwischen dem ersten Element und der Vielzahl von Rollen (5) oder zwischen dem zweiten Element und der Vielzahl von Rollen (5) auf Basis der Impedanz sowie des Phasenwinkels herleitet, wobei
die Herleitungs-Einheit die Ölfilm-Dicke und das Metall-Festkörper-Kontaktverhältnis unter Verwendung einer Berechnungsgleichung herleitet, die einem Stromkreis entspricht, der durch einen Linienkontakt gebildet wird, der zwischen einer Rolle (5) und wenigstens dem ersten oder dem zweiten Element in der Lagerungsvorrichtung (2) auftritt, wobei der durch den Linienkontakt gebildete Stromkreis durch einen Widerstand, der von dem Linienkontakt ausgebildet wird, einen ersten Kondensator, der durch ein Schmiermittel gebildet wird, das innerhalb eines vorgegebenen Bereiches von dem Linienkontakt aus positioniert ist, sowie einen zweiten Kondensator ausgebildet wird, der durch ein Schmiermittel gebildet wird, das außerhalb des vorgegebenen Bereiches positioniert ist, **dadurch gekennzeichnet, dass** die Ölfilm-Dicke (hₐ) eine Ölfilm-Dicke innerhalb des vorgegebenen Bereiches ist, und
die Berechnungsgleichung zum Herleiten der Ölfilm-Dicke hₐ sowie des Metall-Festkörper-Kontaktverhältnisses α wie folgt lautet: $α = \frac{\left|{Z}_{0}\right| cos θ}{\left|Z\right| cos {θ}_{0}}$ ${h}_{a} = \frac{8 {\left(1-α\right)}^{3} {a}^{2}}{r} {\left(\frac{1 + \sqrt{1 + ψ}}{πψ}\right)}^{2}$ und $ψ = - \frac{4 \left(1-α\right) la sin θ}{{π}^{2} nrLεω \left|Z\right|}$
α: Metall-Festkörper-Kontaktverhältnis (0 ≤ a < 1)
Z: komplexe Impedanz
Z₀: komplexe Impedanz (wenn angehalten)
θ: Phasenwinkel
θ₀: Phasenwinkel (wenn angehalten)
r: Radius von Rolle
a: Kontaktbreite in Querrichtung von Rolle
I: Anzahl von Kontaktbereichen pro Rolle
n: Anzahl von Rollen
L Länge von Rolle
ω: Winkelfrequenz von Wechselspannung
ε: Dielektrizitätskonstante von
Schmiermittel
π: pi.

5. Programm, das einen Computer veranlasst zu arbeiten als:
eine Bestimmungs-Einheit, die so ausgeführt ist, dass sie für eine Lagerungsvorrichtung (2) eine Impedanz und einen Phasenwinkel eines Stromkreises, der durch eine Vielzahl von Rollen (5), die die Lagerungsvorrichtung (2) ausbilden sowie das erste und das zweite Element gebildet wird, beim Anlegen einer Wechselspannung bestimmt, die erzeugt werden, wenn die Wechselspannung an den Stromkreis angelegt wird; und
eine Herleitungs-Einheit, die so ausgeführt ist, dass sie eine Ölfilm-Dicke (hₐ) und ein Metall-Festkörper-Kontaktverhältnis (α) wenigstens zwischen dem ersten Element und der Vielzahl von Rollen (5) oder zwischen dem zweiten Element und der Vielzahl von Rollen (5) auf Basis der Impedanz sowie des Phasenwinkels herleitet, wobei
die Herleitungs-Einheit die Ölfilm-Dicke und das Metall-Festkörper-Kontaktverhältnis unter Verwendung einer Berechnungsgleichung herleitet, die einem Stromkreis entspricht, der durch einen Linienkontakt gebildet wird, der zwischen einer Rolle (5) und wenigstens dem ersten oder dem zweiten Element in der Lagerungsvorrichtung (2) auftritt, wobei der durch den Linienkontakt gebildete Stromkreis durch einen Widerstand, der von dem Linienkontakt ausgebildet wird, einen ersten Kondensator, der durch ein Schmiermittel gebildet wird, das innerhalb eines vorgegebenen Bereiches von dem Linienkontakt aus positioniert ist, sowie einen zweiten Kondensator gebildet wird, der durch ein Schmiermittel gebildet wird, das außerhalb des vorgegebenen Bereiches positioniert ist, **dadurch gekennzeichnet, dass**
die Ölfilm-Dicke (hₐ) eine Ölfilm-Dicke innerhalb des vorgegebenen Bereiches ist, und die Berechnungsgleichung zum Herleiten der Ölfilm-Dicke hₐ und des Metall-Festkörper-Kontaktverhältnisses α wie folgt lautet: $α = \frac{\left|{Z}_{0}\right| cos θ}{\left|Z\right| cos {θ}_{0}}$ ${h}_{a} = \frac{8 {\left(1-α\right)}^{3} {a}^{2}}{r} {\left(\frac{1 + \sqrt{1 + ψ}}{πψ}\right)}^{2}$ und $ψ = - \frac{4 \left(1-α\right) la sin θ}{{π}^{2} nrLεω \left|Z\right|}$
α: Metall-Festkörper-Kontaktverhältnis (0 ≤ a < 1)
Z: komplexe Impedanz
Z₀: komplexe Impedanz (wenn angehalten)
θ: Phasenwinkel
θ₀: Phasenwinkel (wenn angehalten)
r: Radius von Rolle
a: Kontaktbreite in Querrichtung von Rolle
I: Anzahl von Kontaktbereichen pro Rolle
n: Anzahl von Rollen
L: Länge von Rolle
ω: Winkelfrequenz von Wechselspannung
ε: Dielektrizitätskonstante von Schmiermittel
π:pi.

## Revendications

1. Procédé de détection pour détecter un état d'un dispositif à roulement (2) incluant une pluralité de rouleaux (5) et des premier et deuxième éléments configurant des surfaces de roulement de la pluralité de rouleaux (5), le procédé comprenant :
une application d'une tension CA à un circuit électrique configuré par la pluralité de rouleaux (5) et les premier et deuxième éléments ;
une mesure d'une impédance et d'un angle de phase de circuit électrique lorsque d'une application de la tension CA ; et
une déduction, selon l'impédance et l'angle de phase, d'une épaisseur de film d'huile et d'un rapport de contact métallique dans au moins un d'entre le premier élément et la pluralité de rouleaux (5) et d'entre le deuxième élément et la pluralité de rouleaux (5), dans lequel
l'épaisseur de film d'huile (hₐ) et le rapport de contact métallique (α) sont déduits en utilisant une équation de calcul correspondant à un circuit électrique configuré par un contact de ligne intervenant entre un rouleau (5) et au moins un des premier et deuxième éléments présents dans le dispositif à roulement (2), et dans lequel le circuit électrique configuré par le contact de ligne est configuré par une résistance formée par le contact de ligne, un premier condensateur configuré par un lubrifiant positionné au sein d'une plage prédéterminée depuis le contact de ligne, et un deuxième condensateur configuré par un lubrifiant positionné hors de la plage prédéterminée, **caractérisé en ce que**
l'épaisseur du film d'huile est une épaisseur de film d'huile au sein de la plage prédéterminée, et
l'équation de calcul pour déduire l'épaisseur de film d'huile hₐ et le rapport de contact métallique α est la suivante : $α = \frac{\left|{Z}_{0}\right| cos θ}{\left|Z\right| {cosθ}_{0}}$ ${h}_{a} = \frac{8 {\left(1-α\right)}^{3} {a}^{2}}{r} {\left(\frac{1 + \sqrt{1 + ψ}}{πψ}\right)}^{2}$ et $ψ = - \frac{4 \left(1-α\right) la sin θ}{{π}^{2} nrLεω \left|Z\right|}$
α : rapport de contact métallique (0 ≤ α ≤ 1)
Z : impédance complexe
Z₀ : impédance complexe (à l'arrêt)
θ : angle de phase
θ₀ : angle de phase (à l'arrêt)
r : rayon de rouleau
a : largeur de contact dans une direction transverse de rouleau
I : nombre de zones de contact par rouleau
n : nombre de rouleaux
L : longueur de rouleau
ω : fréquence angulaire de tension CA
ε : constante diélectrique de lubrifiant
π : pi.

2. Le procédé de détection selon la revendication 1, dans lequel une capacitance C₁ du premier condensateur est exprimée par ${C}_{1} = \frac{2 ε \left(1-α\right) aL}{{h}_{1}}$ et une capacitance C₂ du deuxième condensateur est exprimée par ${C}_{2} = 2 πεL \sqrt{\frac{r}{2 {h}_{1}}}$ h₁ : épaisseur de film d'huile en zone de contact hertzienne.

3. Le procédé de détection selon la revendication 1 ou 2, dans lequel le dispositif à roulement (2) est diagnostiqué en utilisant l'épaisseur de film d'huile et le rapport de contact métallique.

4. Procédé de détection pour détecter un état d'un dispositif à roulement (2) configuré par une pluralité de rouleaux (5) et des premier et deuxième éléments configurant des surfaces de roulement de la pluralité de rouleaux (5), le dispositif comprenant :
une unité d'acquisition configurée pour acquérir une impédance et un angle de phase d'un circuit électrique, configuré par la pluralité de rouleaux (5) et les premier et deuxième éléments, sur application d'une tension CA, obtenue lorsque la tension CA est appliquée au circuit électrique ; et
une unité de déduction configurée pour déduire une épaisseur de film d'huile (hₐ) et un rapport de contact métallique (α) dans au moins un d'entre le premier élément et la pluralité de rouleaux (5) et d'entre le deuxième élément et la pluralité de rouleaux (5) selon l'impédance et l'angle de phase, dans lequel
l'unité de déduction déduit l'épaisseur de film d'huile et le rapport de contact métallique en utilisant une équation de calcul correspondant à un circuit électrique configuré par un contact de ligne intervenant entre un rouleau (5) et au moins un des premier et deuxième éléments présents dans le dispositif à roulement (2), dans lequel le circuit électrique configuré par le contact de ligne est configuré par une résistance formée par le contact de ligne, un premier condensateur configuré par un lubrifiant positionné au sein d'une plage prédéterminée depuis le contact de ligne, et un deuxième condensateur configuré par un lubrifiant positionné hors de la plage prédéterminée, **caractérisé en ce que**
l'épaisseur du film d'huile (hₐ) est une épaisseur de film d'huile au sein de la plage prédéterminée, et
l'équation de calcul pour déduire l'épaisseur de film d'huile hₐ et le rapport de contact métallique α est la suivante : $α = \frac{\left|{Z}_{0}\right| cos θ}{\left|Z\right| {cosθ}_{0}}$ ${h}_{a} = \frac{8 {\left(1-α\right)}^{3} {a}^{2}}{r} {\left(\frac{1 + \sqrt{1 + ψ}}{πψ}\right)}^{2}$ et $ψ = - \frac{4 \left(1-α\right) la sin θ}{{π}^{2} nrLεω \left|Z\right|}$
α : rapport de contact métallique (0 ≤ α ≤ 1)
Z : impédance complexe
Z₀ : impédance complexe (à l'arrêt)
θ : angle de phase
θ₀ : angle de phase (à l'arrêt)
r : rayon de rouleau
a : largeur de contact en direction transverse de rouleau
I : nombre de zones de contact par rouleau
n : nombre de rouleaux
L : longueur de rouleau
ω : fréquence angulaire de tension CA
ε : constante diélectrique de lubrifiant
π : pi.

5. Programme faisant fonctionner un ordinateur tel que :
une unité d'acquisition configurée pour acquérir, pour un dispositif à roulement (2), une impédance et un angle de phase d'un circuit électrique, configuré par une pluralité de rouleaux (5) configurant le dispositif à roulement (2) et des premier et deuxième éléments configurant des surfaces de roulement de la pluralité de rouleaux (5), sur application d'une tension CA, obtenue lorsque la tension CA est appliquée au circuit électrique ; et
une unité de déduction configurée pour déduire une épaisseur de film d'huile (hₐ) et un rapport de contact métallique (α) dans au moins un d'entre le premier élément et la pluralité de rouleaux (5) et d'entre le deuxième élément et la pluralité de rouleaux (5) selon l'impédance et l'angle de phase, dans lequel
l'unité de déduction déduit l'épaisseur de film d'huile et le rapport de contact métallique en utilisant une équation de calcul correspondant à un circuit électrique configuré par un contact de ligne intervenant entre un rouleau (5) et au moins un des premier et deuxième éléments présents dans le dispositif à roulement (2), dans lequel le circuit électrique configuré par le contact de ligne est configuré par une résistance formée par le contact de ligne, un premier condensateur configuré par un lubrifiant positionné au sein d'une plage prédéterminée depuis le contact de ligne, et un deuxième condensateur configuré par un lubrifiant positionné hors de la plage prédéterminée, **caractérisé en ce que**
l'épaisseur du film d'huile (hₐ) est une épaisseur de film d'huile au sein de la plage prédéterminée, et
l'équation de calcul pour déduire l'épaisseur de film d'huile hₐ et le rapport de contact métallique α est la suivante : $α = \frac{\left|{Z}_{0}\right| cos θ}{\left|Z\right| {cosθ}_{0}}$ ${h}_{a} = \frac{8 {\left(1-α\right)}^{3} {a}^{2}}{r} {\left(\frac{1 + \sqrt{1 + ψ}}{πψ}\right)}^{2}$ et $ψ = - \frac{4 \left(1-α\right) la sin θ}{{π}^{2} nrLεω \left|Z\right|}$
α : rapport de contact métallique (0 ≤ α ≤ 1)
Z : impédance complexe
Z₀ : impédance complexe (à l'arrêt)
θ : angle de phase
θ₀ : angle de phase (à l'arrêt)
r : rayon de rouleau
a : largeur de contact en direction transverse de rouleau
I : nombre de zones de contact par rouleau
n : nombre de rouleaux
L : longueur de rouleau
ω : fréquence angulaire de tension CA
ε : constante diélectrique de lubrifiant
π : pi.
